# EUROPEAN PATENT APPLICATION

(11) **EP 4 393 995 A1**
(43) Date of publication of application: **03.07.2024**
(21) Application number: 22861322.0
(22) Date of filing: 22.08.2022
(51) Int. Cl.: C08L 29/14, C08L 101/02, C09D 129/02, C09D 129/14, C09D 163/02, C09D 171/10, C08L 71/08, H05K 3/28

(54) **CIRCUIT SHEET, SENSOR SHEET, AND FILM-FORMING COMPOSITION**

(30) Priority: 25.08.2021 JP 2021137254
(71) Applicant: Sekisui Polymatech Co., Ltd., Saitama-city, Saitama 338-0837 (JP)
(72) Inventor: TOMOOKA Shinichi, Saitama-city, Saitama 338-0837 (JP); MIYANAGA Kanae, Saitama-city, Saitama 338-0837 (JP)
(74) Representative: Markfort, Iris-Anne Lucie
(86) International application number: PCT/JP2022/031597
(87) International publication number: WO 2023/027034

(57) **Abstract**

To provide a coating film-forming composition used for forming a coating film that is a protective film having a high capability to protect a circuit wire or sensor electrode and a small thickness and a circuit sheet or sensor sheet that includes a circuit wire or sensor electrode protected with the coating film.

Provided is a circuit sheet or sensor sheet that includes a thermoplastic resin including at least one selected from an epoxy resin, a phenoxy resin, polyvinyl alcohol, polyvinyl acetal, polyvinyl butyral, and an ethylene-vinyl alcohol copolymer and having a hydrogen-bonding functional group and a glass transition temperature Tg of 70°C or more and 150°C or less.

## Description

### Technical Field

The present disclosure relates to a coating film-forming composition used for forming a coating film included in a circuit sheet, a sensor sheet, or the like as a protective layer and a circuit sheet or sensor sheet that includes such a coating film.

### Background Art

Some of the conductive wires included in circuit sheets or the sensor electrodes included in sensor sheets are composed of a silver paste containing silver or a transparent conductive polymer referred to as "PEDOT/PSS". In order to protect such conductive wires or sensor electrodes from wire breakage, corrosion, or the like, circuit sheets or sensor sheets include a highly transparent protective layer that covers the surfaces of the conductive wires or sensor electrodes.

The silver paste or the transparent conductive polymer is likely to become degraded by water vapor, ultraviolet light, or the like or sulfurized by a sulfur gas or the like. Therefore, the protective layer is required to have a property of reducing the occurrence of the above phenomena. A method for covering a conductive wire with a protective layer is described in, for example, Japanese Patent No. 6167103 (PTL 1).

### Citation List

### Patent Literature

PTL 1: Japanese Patent No. 6167103

### Summary of Invention

### Technical Problem

Accordingly, an object of the present disclosure is to enhance the capability to protect a circuit sheet or sensor sheet.

### Solution to Problem

A circuit sheet according to an aspect of the present disclosure includes a substrate sheet, a circuit wire disposed on the substrate sheet, the circuit wire including silver, copper, or a conductive polymer, and an electrically insulating protective layer that covers the circuit wire. The protective layer is a coating film including a thermoplastic resin having a hydrogen-bonding functional group and a glass transition temperature Tg of 70°C or more and 150°C or less. The thermoplastic resin includes at least one selected from an epoxy resin, a phenoxy resin, polyvinyl alcohol, polyvinyl acetal, polyvinyl butyral, and an ethylene-vinyl alcohol copolymer.

According to this aspect of the present disclosure, the electrically insulating protective layer that covers the circuit wire includes a thermoplastic resin that has a hydrogen-bonding functional group and a glass transition temperature Tg of 70°C or more and 150°C or less and includes at least one selected from an epoxy resin, a phenoxy resin, polyvinyl alcohol, polyvinyl acetal, polyvinyl butyral, and an ethylene-vinyl alcohol copolymer. This reduces the likelihood of the circuit wire, which is disposed on the substrate sheet and includes silver, copper, or a conductive polymer, becoming sulfurized or degraded by water vapor, ultraviolet light, or the like and consequently enables the production of a circuit sheet having an enhanced protection capability.

In a circuit sheet according to another aspect, the hydrogen-bonding functional group of the thermoplastic resin is a hydroxyl group, and the thermoplastic resin has a hydroxyl value of 180 mgKOH/g or more and 330 mgKOH/g or less.

According to this aspect, since the hydrogen-bonding functional group of the thermoplastic resin is a hydroxyl group and the thermoplastic resin has a hydroxyl value of 180 mgKOH/g or more and 330 mgKOH/g or less, the circuit sheet is covered with a coating film excellent in terms of adhesion to the substrate sheet, sulfur resistance, etc.

In a coating film-forming composition according to another aspect, the thermoplastic resin has a number-average molecular weight Mn of 2,000 or more and 130,000 or less or a weight-average molecular weight Mw of 5,000 or more and 200,000 or less.

According to this aspect, since the thermoplastic resin has a number-average molecular weight Mn of 2,000 or more and 130,000 or less or a weight-average molecular weight Mw of 5,000 or more and 200,000 or less, the circuit sheet is covered with a coating film having a relatively high glass transition temperature Tg and excellent fastness.

In a circuit sheet according to another aspect, the protective layer does not include a crosslinking agent.

According to this aspect, since the protective layer does not include a crosslinking agent, the circuit sheet is covered with a protective layer that is a coating film free from troubles such as staining, which are caused due to degradation, reaction, or the like of a crosslinking agent when the protective layer includes a crosslinking agent.

In a circuit sheet according to another aspect, the thermoplastic resin is a bisphenol-A phenoxy resin.

According to this aspect, since the protective layer is composed of a thermoplastic resin that is a bisphenol-A phenoxy resin, the circuit sheet includes a protective layer having excellent sulfur resistance.

In a circuit sheet according to another aspect, the thermoplastic resin is a polyvinyl butyral resin having a hydroxyl value of 280 mgKOH/g or more and 330 mgKOH/g or less.

According to this aspect, since the protective layer is composed of the thermoplastic resin that is a polyvinyl butyral resin having a hydroxyl value of 280 mgKOH/g or more and 330 mgKOH/g or less, the circuit sheet includes a protective layer having excellent sulfur resistance.

In a circuit sheet according to another aspect, the protective layer includes at least one additive selected from a humidity resistance improver, a sulfur resistance improver, a gas barrier property improver, a lightfastness improver, an ultraviolet inhibitor, and an adhesion improver, and a content of the at least one additive in the protective layer is 0.1% by volume or more and 15% by volume or less.

According to this aspect, since the protective layer includes at least one additive selected from a humidity resistance improver, a sulfur resistance improver, a gas barrier property improver, a lightfastness improver, an ultraviolet inhibitor, and an adhesion improver, and the content of the additive in the protective layer is 0.1% by volume or more and 15% by volume or less, the protective layer further has at least one selected from a capability to enhance moisture resistance, a capability to enhance sulfur resistance, a capability to enhance gas barrier property, a capability to enhance lightfastness, a capability to inhibit ultraviolet radiation, and a capability to enhance adhesion, that is, the quality of the protective layer can be enhanced. Furthermore, the quality of the electrically conductive portion (i.e., a circuit wire or sensor electrode) covered with the protective layer can also be protected.

In a circuit sheet according to another aspect, the protective layer is bent or stretched.

According to this aspect, since the circuit sheet includes a protective layer that is bent or stretched, a three-dimensionally arranged circuit wire can be protected. Moreover, a three-dimensional circuit sheet can be produced. When the circuit sheet has a three-dimensional shape including a curved surface, the circuit sheet can be formed so as to follow the shape of the space to which the circuit sheet is applied. This increases the degree of freedom of design of an apparatus that includes the circuit sheet.

In a circuit sheet according to another aspect, the substrate sheet has a glass transition temperature Tg of 100°C or more and 150°C or less.

According to this aspect, since the substrate sheet has a glass transition temperature Tg of 100°C or more and 150°C or less, distortion, deformation, cracking, and the like is unlikely to occur when the circuit sheet is heated, bent, and stretched to form a three-dimensional shape.

A sensor sheet according to another aspect includes any one of the above-described circuit sheets and a sensor electrode disposed on the substrate sheet, the sensor electrode including silver, copper, or a conductive polymer. The protective layer included in the circuit sheet is an electrically insulating protective layer that covers the circuit wire included in the circuit sheet and the sensor electrode.

According to this aspect, since the electrically insulating protective layer that covers the circuit wire includes a thermoplastic resin that has a hydrogen-bonding functional group and a glass transition temperature Tg of 70°C or more and 150°C or less and includes at least one selected from an epoxy resin, a phenoxy resin, polyvinyl alcohol, polyvinyl acetal, polyvinyl butyral, and an ethylene-vinyl alcohol copolymer, the likelihood of the circuit wire, which is disposed on the substrate sheet and includes silver, copper, or a conductive polymer, becoming sulfurized is reduced. In addition, the likelihood of the sensor electrode, which includes silver, copper, or a conductive polymer, becoming sulfurized or degraded by water vapor, ultraviolet light, or the like is reduced. Consequently, a sensor sheet having an enhanced protection capability can be produced.

In a sensor sheet according to another aspect, the protective layer is bent or stretched.

According to this aspect, since the sensor sheet includes a protective layer that is bent or stretched, a three-dimensionally arranged circuit wire or sensor electrode can be protected. Moreover, a three-dimensional sensor sheet can be produced. When the sensor sheet has a three-dimensional shape including a curved surface, the sensor sheet can be formed so as to follow the shape of the space to which the sensor sheet is applied. This increases the degree of freedom of design of an apparatus that includes the circuit sheet.

In a sensor sheet according to another aspect, the substrate sheet is a three-dimensional formed body, the circuit sheet has a three-dimensional shape, and the protective layer has at least one selected from a portion bent so as to follow the three-dimensional shape, a portion curved so as to follow the three-dimensional shape, and a portion stretched so as to follow the three-dimensional shape.

According to this aspect, since the protective layer has at least one selected from a portion bent so as to follow the three-dimensional shape, a portion curved so as to follow the three-dimensional shape, and a portion stretched so as to follow the three-dimensional shape, a three-dimensionally arranged circuit wire or sensor electrode can be protected. Moreover, a three-dimensional sensor sheet can be produced. When the sensor sheet has a three-dimensional shape including a curved surface, the sensor sheet can be formed so as to follow the shape of the space to which the sensor sheet is applied. This increases the degree of freedom of design of an apparatus that includes the circuit sheet.

A coating film-forming composition according to an aspect of the present disclosure includes a thermoplastic resin having a glass transition temperature Tg of 70°C or more and 150°C or less and a solvent. The thermoplastic resin includes at least one selected from an epoxy resin, a phenoxy resin, polyvinyl alcohol, polyvinyl acetal, polyvinyl butyral, and an ethylene-vinyl alcohol copolymer and has a hydrogen-bonding functional group.

According to this aspect of the present disclosure, since the composition includes a thermoplastic resin having a glass transition temperature Tg of 70°C or more and 150°C or less and a solvent and the thermoplastic resin includes at least one selected from an epoxy resin, a phenoxy resin, polyvinyl alcohol, polyvinyl acetal, polyvinyl butyral, and an ethylene-vinyl alcohol copolymer and has a hydrogen-bonding functional group, the composition has excellent printability and a thin coating film having suitable qualities, such as sulfur resistance, can be formed. Furthermore, a circuit sheet or sensor sheet having an enhanced protection capability can be formed. Note that the term "sulfur resistance" used herein refers to resistance to degradation that occurs when the coating film is combined with a sulfur component included in air.

In a coating film-forming composition according to another aspect, the hydrogen-bonding functional group of the thermoplastic resin is a hydroxyl group, and the thermoplastic resin has a hydroxyl value of 180 mgKOH/g or more and 330 mgKOH/g or less.

According to this aspect, since the hydrogen-bonding functional group of the thermoplastic resin is a hydroxyl group, and the thermoplastic resin has a hydroxyl value of 180 mgKOH/g or more and 330 mgKOH/g or less, the composition has suitable wettability and adhesion to an adherend, such as a substrate sheet, and excellent printability accordingly. Thus, a thin coating film having suitable qualities, such as sulfur resistance, can be formed.

In a coating film-forming composition according to another aspect, the thermoplastic resin has a number-average molecular weight Mn of 2,000 or more and 130,000 or less or a weight-average molecular weight Mw of 5,000 or more and 200,000 or less.

According to this aspect, since the thermoplastic resin has a number-average molecular weight Mn of 2,000 or more and 130,000 or less or a weight-average molecular weight Mw of 5,000 or more and 200,000 or less, a relatively high glass transition temperature Tg can be achieved and a coating film having excellent fastness can be formed.

A coating film-forming composition according to another aspect does not include a crosslinking agent.

According to this aspect, since the composition does not include a crosslinking agent, the resulting coating film is free from troubles, such as staining, caused due to degradation, reaction, or the like of a crosslinking agent when the coating film includes a crosslinking agent. Furthermore, since the composition is not crosslinked and remains as a thermoplastic resin, the resulting coating film (i.e., protective film) can be bent or stretched by heat and readily formed into a three-dimensional shape.

In a coating film-forming composition according to another aspect, the thermoplastic resin is a bisphenol-A phenoxy resin.

According to this aspect, since the thermoplastic resin included in the coating film-forming composition is a bisphenol-A phenoxy resin, sulfur resistance is unlikely to become degraded even when a circuit sheet or sensor sheet on which the coating film is disposed is formed into a three-dimensional shape.

In a coating film-forming composition according to another aspect, the thermoplastic resin is a polyvinyl butyral resin having a hydroxyl value of 280 mgKOH/g or more and 330 mgKOH/g or less.

According to this aspect, since the thermoplastic resin is a polyvinyl butyral resin having a hydroxyl value of 280 mgKOH/g or more and 330 mgKOH/g or less, a coating film having excellent sulfur resistance can be formed. Advantageous Effects of Invention

According to an aspect of the present disclosure, a coating film-forming composition having suitable printability can be provided.

According to an aspect of the present disclosure, a coating film having excellent sulfur resistance can be provided.

According to an aspect of the present disclosure, a circuit sheet or sensor sheet that includes a coating film having excellent sulfur resistance can be provided.

### Brief Description of Drawings

[Fig. 1] Fig. 1 includes schematic diagrams illustrating a circuit sheet according to an aspect of the present disclosure, where Fig. 1A is a front view and Fig. 1B is a plan view.
[Fig. 2] Fig. 2 includes schematic diagrams illustrating a sensor sheet according to an aspect of the present disclosure, where Fig. 2A is a front view and Fig. 2B is a plan view.
[Fig. 3] Fig. 3 includes schematic diagrams illustrating a sensor sheet according to another aspect of the present disclosure, where Fig. 3A is a cross-sectional view taken along the line IIIA-IIIA of Fig. 3B and Fig. 3B is a plan view.
[Fig. 4] Fig. 4 includes schematic diagrams illustrating a sensor sheet according to another aspect of the present disclosure, where Fig. 4A is a cross-sectional view taken along the line IVA-IVA of Fig. 4B and Fig. 4B is a plan view.

### Description of Embodiments

An exemplary embodiment according to an aspect of the present disclosure is described with reference to the attached drawings below. It should be noted that the aspect and embodiments described below are not intended to improperly limit the scope of the present invention described in the claims and all the components described in the following embodiments are not always necessary as solutions for the present invention.

Note that the terms "first" and "second" used in the description and the claims are used to distinguish different components from one another but not used to indicate a specific order, superiority or inferiority, or the like. Components that are common to all the embodiments and have the same advantageous effects are denoted with the same reference numeral, and descriptions thereof are omitted.

### <Coating Film-Forming Composition>

For example, a coating film-forming composition described in this embodiment is applied to a substrate sheet for circuit sheets, sensor sheets, or the like and serves as a protective layer that protects a circuit wire (i.e., conductive wire) or a sensor electrode. The coating film-forming composition has high transparency and a high capability to protect the target that is to be covered. The coating film-forming composition includes a thermoplastic resin having a glass transition temperature Tg of 70°C or more and 150°C or less and a solvent. The thermoplastic resin includes at least one selected from an epoxy resin, a phenoxy resin, polyvinyl alcohol, polyvinyl acetal, polyvinyl butyral, and an ethylene-vinyl alcohol copolymer and has a hydrogen-bonding functional group. The components of the coating film-forming composition are described below.

Thermoplastic Resin: In the coating film-forming composition is a thermoplastic resin that includes at least one selected from an epoxy resin, a phenoxy resin, polyvinyl alcohol, polyvinyl acetal, polyvinyl butyral, and an ethylene-vinyl alcohol copolymer and has a glass transition temperature Tg of 70°C or more and 150°C or less.

One of the reasons for which a thermoplastic resin is used is that, even in the case where the circuit sheet or sensor sheet is formed into a three-dimensional shape, the resulting coating film has an adaptability to the deformation stress caused when the circuit sheet or sensor sheet is formed into a three-dimensional shape and high adhesion to the substrate sheet. In addition, it becomes not necessary to use a crosslinking agent, which is used in the case where a thermosetting resin is used. This eliminates the possibility of troubles, such as degradation, reaction with another additive, occurring when a crosslinking agent is used.

Since the glass transition temperature Tg is 70°C or more and 150°C or less, excellent sulfur resistance can be achieved. However, if the glass transition temperature Tg is less than 70°C or more than 150°C, formability may become degraded. The glass transition temperature Tg is more preferably 70°C or more and 110°C or less in order to enhance properties such as sulfur resistance. The glass transition temperature Tg is more preferably 80°C or more in order to enhance properties such as sulfur resistance. The above glass transition temperature Tg can be determined using thermomechanical analysis (TMA), differential scanning calorimetry (DSC), differential thermal analysis (DTA), thermogravimetric analysis (TGA), or the like.

The thermoplastic resin preferably includes a hydrogen-bonding functional group. The hydrogen-bonding functional group enables hydrogen bonds to be formed in or between molecules, which produce positive impacts on sulfur resistance. The larger the amount of the hydrogen-bonding functional group, the higher the glass transition temperature Tg of the thermoplastic resin. Examples of the hydrogen-bonding functional group include a hydroxyl group, an amino group, a carboxyl group, a ketone group, an aldehyde group, a nitro group, a sulfo group, an amide bond, a urethane linkage, a urea linkage, and an ether linkage. A hydrogen bond is formed between a functional group that serves as a hydrogen-bond donor and a functional group that serves as a hydrogen-bond acceptor.

It is preferable that the hydrogen-bonding functional group of the thermoplastic resin be a hydroxyl group and the thermoplastic resin have a hydroxyl value of 180 mgKOH/g or more and 330 mgKOH/g or less. A hydroxyl value is the number of milligrams of potassium hydroxide which corresponds to the amount of hydroxyl groups included in one gram of a sample. When the hydroxyl value is 180 mgKOH/g or more and 330 mgKOH/g or less, the amount of hydroxyl groups and the amount of hydrogen bonds formed in and between molecules are increased and, accordingly, and positive impacts on sulfur resistance can be produced consequently. Moreover, the presence of hydroxyl groups increases adhesion to the substrate sheet. The hydroxyl value is further preferably 190 mgKOH/g or more in order to enhance properties such as sulfur resistance. The hydroxyl value can be determined using, for example, the hydroxyl value measuring method described in JIS-K 0070;1992.

Among the above thermoplastic resins, a phenoxy resin and a polyvinyl butyral resin are preferable because these resins have excellent adhesion to the resins used for forming the substrate sheet and excellent sulfur resistance. A phenoxy resin is also referred to as "polyhydroxy polyether resin". Examples of the phenoxy resin that can be used include a bisphenol-A phenoxy resin, a bisphenol-AD phenoxy resin, a bisphenol-E phenoxy resin, a bisphenol-F phenoxy resin, and mixtures thereof. The phenoxy resin is more preferably a bisphenol-A phenoxy resin because it has a relatively high glass transition temperature. This is because, even in the case where a stress is applied to the protective layer when the circuit sheet or sensor sheet is formed into a three-dimensional shape after the protective layer has been formed on the substrate sheet, a bisphenol-A phenoxy resin has excellent adhesion to the substrate sheet, the sulfur resistance does not change after the circuit sheet or sensor sheet has been formed into a three-dimensional shape, and the sulfur resistance remains at a level comparable to that of sulfur resistance achieved before the circuit sheet or sensor sheet is formed into a three-dimensional shape. It is more preferable that the thermoplastic resin be a polyvinyl butyral resin having a hydroxyl value of 280 KOH/g or more and 330 mgKOH/g or less. Since it has a high hydroxyl value, positive impacts on sulfur resistance can be produced. Moreover, since having a hydroxyl group, a polyvinyl butyral resin has excellent adhesion to the resins used for forming the substrate sheet. Note that "polyvinyl acetal resin" is a general term for resins produced by acetalizing a polyvinyl alcohol with an aldehyde in the presence of an acid, and a polyvinyl butyral resin is a resin produced by acetalizing a polyvinyl alcohol using butanol (butyl alcohol) as an aldehyde.

As for the average molecular weight of the thermoplastic resin, it is preferable that the number-average molecular weight Mn be 2,000 or more and 130,000 or less and the weight-average molecular weight Mw be 5,000 or more and 200,000 or less. This is because, when the average molecular weight of the thermoplastic resin falls within the above range, a relatively high glass transition temperature Tg can be achieved and a coating film having excellent fastness can be formed.

It is preferable to set the content of the thermoplastic resin in the coating film-forming composition to 5% by weight or more and 60% by weight or less and preferably to 10% by weight or more and 40% by weight or less in order to achieve a suitable viscosity by using the thermoplastic resin in combination with a solvent suitable to the thermoplastic resin. If the content of the thermoplastic resin in the coating film-forming composition is less than 5% by weight, it becomes difficult to form a coating film having an intended thickness. If the above content is more than 60% by weight, viscosity is increased to an excessive degree, which results in degradation of printability. When the above content is 10% by weight or more and 40% by weight or less, a coating film-forming composition having suitable printability can be produced.

Solvent: The solvent is a material in which the thermoplastic resin is dissolved or dispersed and which imparts an adequate viscosity to the resulting solution or dispersion to form a composition having properties appropriate for coating liquids. The above solvent may be selected from solvents appropriate for dissolving or dispersing the thermoplastic resin therein, in accordance with the type of the thermoplastic resin. For example, diethylene glycol monobutyl ether may be used for a phenoxy resin or a polyvinyl butyral resin. This combination of a thermoplastic resin and a solvent is excellent in terms of the volatility of the solvent and the solubility of the thermoplastic resin. The content of the solvent is set to an amount with which the thermoplastic resin and the additives can be dissolved or dispersed in the solvent and the solvent can be volatilized within an adequate period of time and allows the formation of a coating film having an intended thickness.

Solvents other than the above solvents may also be used. Examples thereof include alcohols, such as methanol, ethanol, n-propanol, isopropanol, ethylene glycol, propylene glycol, 3-methoxy-1-butanol, ethylene glycol monobutyl ether, 3-hydroxy-2-butanone, and diacetone alcohol; terpenes, such as α- or β-terpineol; ketones, such as acetone, methyl ethyl ketone, cyclohexanone, and N-methyl-2-pyrrolidone; aromatic hydrocarbons, such as toluene, xylene, and tetramethylbenzene; glycol ethers, such as cellosolve, methyl cellosolve, ethyl cellosolve, carbitol, methyl carbitol, ethyl carbitol, butyl carbitol, propylene glycol monomethyl ether, propylene glycol monoethyl ether, dipropylene glycol monomethyl ether, dipropylene glycol monoethyl ether, triethylene glycol monomethyl ether, and triethylene glycol monoethyl ether; and esters, such as ethyl acetate, butyl acetate, ethyl lactate, cellosolve acetate, ethyl cellosolve acetate, butyl cellosolve acetate, carbitol acetate, ethyl carbitol acetate, butyl carbitol acetate, propylene glycol monomethyl ether acetate, and propylene glycol monoethyl ether acetate. The above solvents may be used in combination in the form of a mixed solvent.

Additive: Adding various additives to the composition in which the thermoplastic resin is dissolved or dispersed enables properties that cannot be produced by only dissolving or dispersing the thermoplastic resin in the composition to be imparted to the composition.

Examples of the additives that can be used as a printability improver for enhancing printability include a viscosity modifier used for adjusting viscosity, such as a plasticizer; a thixotropy imparting agent used for imparting thixotropy; a foaming inhibitor used for inhibiting the occurrence of foaming during printing, such as an antifoaming agent; a stringiness inhibitor used for inhibiting stringiness; a wettability improver used for reducing repellency on a print substrate and preventing unevenness of printing and formation of mottled pattern; and a dryness improver used for performing continuous printing. Examples of the additives also include coating liquid stabilizers used for stabilizing the properties of the coating film-forming composition, such as a silane coupling agent, a polymerization inhibitor, and an antioxidant.

Examples of the additives further include a smoothing agent used for enhancing the surface smoothness of a coating film formed using the composition, which can be used as a coating film quality improver for enhancing the qualities of a coating film in order to enhance the qualities of the coating film. Examples of the additives that can be used to protect the qualities of electrically conductive portions covered with the coating film serving as a protective layer include a humidity resistance improver used for enhancing humidity resistance, a sulfur resistance improver used for enhance sulfur resistance, a gas barrier property improver used for reducing gas permeability, such as oxygen permeability, a heat resistance improver used for enhancing heat resistance, a lightfastness improver used for inhibiting discoloration, an ultraviolet inhibitor used for inhibiting penetration of ultraviolet radiation, and an adhesion improver used for increasing adhesion to the substrate sheet. Among these, the humidity resistance improver, the sulfur resistance improver, the gas barrier property improver, the heat resistance improver, the lightfastness improver, and the ultraviolet inhibitor are considered as weather resistance improvers in consideration of the properties of the protective layer. It is also considered that the above terms each express one of the functions of a barrier property improver. The above additives can be used alone or in combination of two or more as needed.

For example, a functional filler, such as titanium oxide or zinc oxide, serves as an agent for enhancing the qualities of the coating film, such as a humidity resistance improver that reduces water vapor permeability, an ultraviolet inhibitor that inhibits penetration of ultraviolet radiation, a sulfur resistance improver that reduces sulfur gas permeability, or a gas barrier property improver. The functional filler may also serve as a printability improver, such as a viscosity modifier, a foaming inhibitor, or a thixotropy imparting agent.

The content of the additive in the coating film-forming composition is preferably 0.1% by volume or more and 15% by volume or less and is preferably 3% by volume or more and 10% by volume or less. This is because printability may become degraded if the content of the additive is less than 0.1% by volume and the qualities of the coating film may become degraded if the above content is more than 10% by volume. When the above content is 3% by volume or more and 10% by volume or less, the coating film-forming composition has suitable printability and a quality coating film can be formed.

Preparation of Coating Film-Forming Composition: The coating film-forming composition is prepared by dissolving or dispersing the thermoplastic resin in the solvent, adding the additives to the resulting solution or dispersion as needed, and then performing stirring. The viscosity of the coating film-forming composition which is measured using a rotary viscometer at a rotation speed of 10 rpm and 25°C is preferably 1 Pa·s or more and 300 Pa·s or less. If the viscosity of the coating film-forming composition is less than 1 Pa·s, the capability of a patterned circuit wire to maintain its shape may become degraded. If the above viscosity is more than 300 Pa·s, for example, clogging is likely to occur during screen printing, which is one of the typical coating methods, and productivity may be reduced. The above viscosity can be measured using, for example, a rotary viscometer (rotary viscometer DV-E produced by BROOKFIELD)(spindle: SC4-14 and chamber: SC4-6R/RP are used, rotation speed: 5 rpm, measurement temperature: 25°C).

The above-described coating film-forming composition has an adequate viscosity and suitable printability to the substrate sheet. Furthermore, the coating film-forming composition reduces the likelihood of pinholes or the like being formed during coating, such as printing, and enables the formation of a flat and smooth coating film. In addition, a coating film used as a high-quality protective layer can be produced by curing the coating film-forming composition.

Formation of Coating Film: The coating film-forming composition is applied to a substrate sheet, such as a resin film, by screen printing or the like and then solidified to form a coating film, which can be used as a protective layer for the substrate sheet. The protective layer is preferably a coating film having high transparency. The average light transmittance of the protective layer at visible wavelengths of 400 nm to 800 nm is preferably 80% or more and is further preferably 85% or more. Examples of coating methods other than screen printing which can be used include spray coating, coater printing, transfer printing, and immersion coating.

The thickness of the coating film that serves as a protective layer for protecting the circuit wire or sensor electrode may be 0.5 um or more and 50 um or less, is preferably 3 um or more and 30 um or less, and is more preferably 5 um or more and 8 um or less. This is because, although the coating film that serves as a protective layer can be formed so as to have a thickness of more than 10 µm, it defies the request for thickness reduction. Furthermore, if the above thickness is smaller than 3 µm, the circuit wire or sensor electrode may fail to be protected in a sufficient manner. However, depending on the application, thickness may be increased by stacking the coating films on top of one another. It is possible to increase the film thickness to about 100 um.

The above-described coating film has excellent sulfur resistance and may have suitable moisture resistance, suitable lightfastness, suitable sulfur resistance, low reactivity with chemicals, and a suitable solvent barrier property. The coating film preferably has low volatility and is preferably free from bleeding out. The coating film is resistant to migration to other members that are in intimate contact with the surface of the coating film and a non-resin attack property and is unlikely to contaminate the other members.

Forming the above-described coating film as a protective layer enables the thickness reduction and enhances the capability to protect the target that is to be covered. Furthermore, forming a circuit sheet or sensor sheet that includes the above protective layer may enable the thickness reduction and enhance the protection capability. This also meets market demands for thickness reduction and cost reduction.

### <Circuit Sheet>

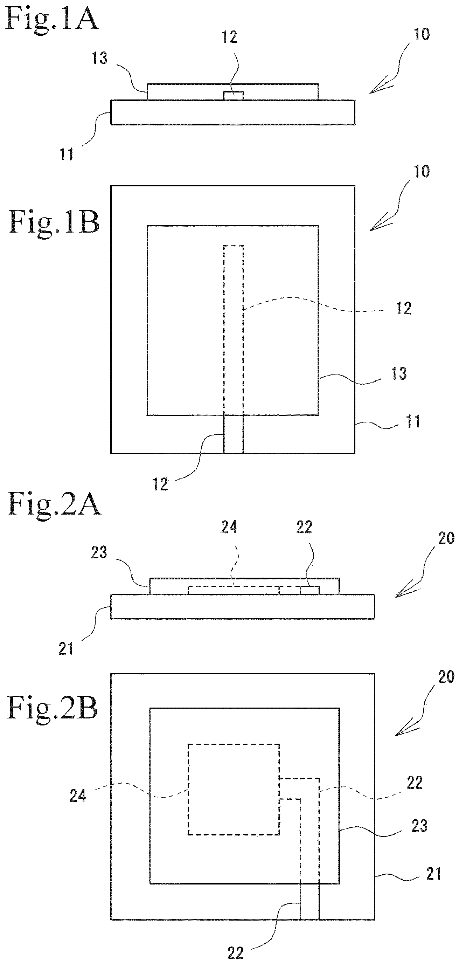

Figs. 1A and 1B are front and plan views, respectively, of an embodiment that includes a protective layer formed using the coating film-forming composition. The circuit sheet 10 illustrated in the drawings is a circuit sheet produced by applying the coating film-forming composition so as to cover a conductive wire 12 disposed on a substrate sheet 11 to form a protective layer 13. In the drawings, the number of the conductive wires 12 constituting a circuit is only one for illustrative purpose. In the drawings, each of the components is magnified in the thickness direction compared with the width direction for ease of understanding of the layer structure and the aspect ratio of the component is different from the actual one.

Substrate Sheet: The substrate sheet 11, which serves as a substrate for the circuit sheet, is preferably a transparent resin film. Examples of such resin films include a polyethylene terephthalate (PET) resin, a polyethylene naphthalate (PEN) resin, a polycarbonate (PC) resin, a methacryl (PMMA) resin, a polypropylene (PP) resin, a polyurethane (PU) resin, a polyamide (PA) resin, a polyethersulfone (PES) resin, a polyether ether ketone (PEEK) resin, a triacetyl cellulose (TAC) resin, and a thermoplastic resin (COP). The glass transition temperature Tg of the substrate sheet is preferably 100°C or more and 150°C or less in order to reduce the likelihood of distortion, deformation, cracking, or the like occurring when the circuit sheet or sensor sheet is bent or stretched by heat to be formed into a three-dimensional shape. The substrate sheet 11 may also be a coating film formed using the coating film-forming composition. The substrate sheet 11 may be provided with, for example, a primer layer that increases adhesion to the conductive wire 12 or the protective layer 13, a surface protective layer, or an overcoat layer for antistatic purpose and the like. The substrate sheet 11 may be subjected to a surface treatment, such as a corona treatment, a plasma treatment, or an ultraviolet irradiation treatment.

Circuit Wire: Although the number of the conductive wires 12 constituting the circuit wire illustrated in Fig. 1 is only one for the sake of simplicity of explanation, a circuit (circuit wire) is commonly constituted by a plurality of the conductive wires 12 arranged on the substrate sheet 11 in a pattern. Examples of the material constituting the conductive wire 12 include a conductive paste or conductive ink that includes a mixture of a synthetic resin, a solvent, and the like, which serves as a vehicle, and a powder of a highly conductive metal, such as copper, aluminum, silver, or an alloy containing (powders of) these metals. Among the above metals and alloys, a silver wire that is composed primarily of silver is preferably used because it has high conductivity and is more resistant to oxidation than copper. The conductive wire 12 may also be a wire composed of a graphite powder or a powder of carbon, such as carbon fibers or carbon black. The conductive wire 12 may also be a wire composed of a mixture including the above material and a metal. The conductive wire 12 may also be a wire composed of a transparent conductive polymer.

Examples of the transparent conductive polymer include polythiophene, polypyrrole, polyaniline, polyparaphenylene, and polyacetylene. Specific examples thereof include PEDOT/PSS (poly-3,4-ethylenedioxythiophene-polystyrenesulfonic acid). The transparent conductive polymer may be a commercial one that is provided as a printing ink in the form of a paint. Alternatively, a wire formed using a highly transparent conductive paste or conductive ink, such as a conductive paste or conductive ink including metal nanoparticles (e.g., silver nanoparticles), carbon nanoparticles, indium tin oxide (ITO) powder particles, or the like, may also be used.

The circuit wire may be formed by a method other than printing; the circuit wire may be formed by forming an electrically conductive portion on the substrate sheet 11 using metal vapor deposition, and subsequently removing unnecessary portions by etching or the like in order to create a circuit pattern. In the case where metal vapor deposition is performed, metals such as copper, aluminum, nickel, chromium, zinc, and gold can be used. Among these, copper is preferable because it has low electric resistance and is inexpensive.

For producing the circuit sheet 10, a circuit wire (i.e., conductive wire 12) is formed on a transparent resin film, which serves as a substrate sheet 11, at predetermined positions by printing. The coating film-forming composition is applied thereto, and the resulting coating film is cured to form a protective layer 13. A circuit sheet 10 can be formed in the above manner. In the case where the thermoplastic resin or additive included in the coating film-forming composition includes a hydrogen-bonding functional group or a reactive functional group, affinity for the substrate sheet can be enhanced. Moreover, a reaction can be caused. The circuit sheet can be formed into a three-dimensional shape by bending or stretching, similarly to the sensor sheet described below.

### <Sensor Sheet>

Figs. 2A and 2B are front and plan views, respectively, of another embodiment where a coating film formed using a coating film-forming composition is used as a protective layer. The sensor sheet 20 illustrated in the drawings, such as a sensor sheet, includes a protective layer 23 formed by applying the coating film-forming composition so as to cover a conductive wire 22 and a sensor electrode 24 that are disposed on a substrate sheet 21. In the drawings, only one sensor electrode 24 is shown for the sake of simplicity and a sensor sheet 20 that includes a circuit wire and a sensor electrode 24 is described as an example.

Sensor Electrode: The substrate sheet 21 that serves as a substrate for the sensor sheet 20 or the conductive wire 22 is the same as that included in the circuit sheet 10. The sensor electrode 24 can be formed using the conductive paste or conductive ink used for forming the circuit wire, or by metal vapor deposition or the like and may also be formed using a transparent conductive polymer. The use of a highly transparent material allows the sensor position to emit light as a result of backlight illumination permeating therethrough.

Examples of the transparent conductive polymer include polythiophene, polypyrrole, polyaniline, polyparaphenylene, and polyacetylene. Specific examples thereof include PEDOT/PSS (poly-3,4-ethylenedioxythiophene-polystyrenesulfonic acid). The transparent conductive polymer may be a commercial one that is provided as a printing ink in the form of a paint. Alternatively, a sensor electrode 24 formed using a highly transparent conductive paste or conductive ink, such as a conductive paste or conductive ink including metal nanoparticles (e.g., silver nanoparticles), carbon nanoparticles, indium tin oxide (ITO) powder particles, or the like, may also be used.

For producing the sensor sheet 20, a circuit wire (i.e., conductive wire 22) and a sensor electrode 24 are formed on a transparent resin film, which serves as a substrate sheet 21, at predetermined positions by printing. The coating film-forming composition is applied thereto, the solvent is then volatilized, and the resulting coating film is cured to form a protective layer 23. A sensor sheet 20 can be formed in the above manner.

### <Sensor Sheet (Part 2)>

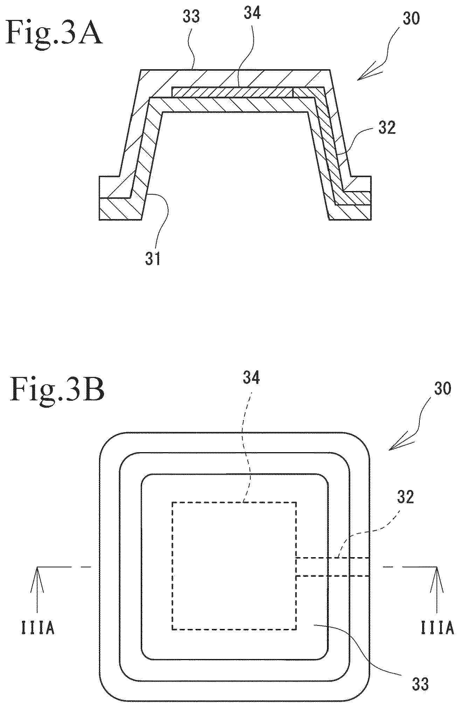

Figs. 3A and 3B are front and plan views, respectively, of a sensor sheet 30 according to another embodiment. The sensor sheet 30 illustrated in the drawings is the same as the above-described sensor sheet 20 in that a circuit wire (conductive wire 32) and a sensor electrode 34 that are disposed on a substrate sheet 31 are covered with a protective layer 33 formed by application of the coating film-forming composition. However, the sensor sheet 30 according to this embodiment is different from the sensor sheet 20 in that the sensor sheet 30 is three-dimensionally formed by bending or stretching so as to be protruded from a surface of the sensor sheet 30 in which the protective layer 33 is disposed. Note that the raw material, etc. of each of the members are the same.

The sensor sheet 30 can be formed by, similarly to the sensor sheet 20, forming a circuit wire (i.e., conductive wire 32), a sensor electrode 34, and a protective layer 33 on and above a tabular substrate sheet 31 and deforming the resulting multilayer body by heat, or by forming a circuit wire (i.e., conductive wire 32), a sensor electrode 34, and a protective layer 33 on and above a substrate sheet 31 provided in a three-dimensional shape by printing, vapor deposition, or the like. In the case where the substrate sheet 31 is deformed by heat in downstream steps, it is preferable that the glass transition temperature Tg of the thermoplastic resin included in the coating film-forming composition that is to be formed into a protective layer 33 be close to the glass transition temperature Tg of the substrate sheet 31. The closer to each other the above glass transition temperatures Tg, the smaller the difference in the degrees of deformation of the substrate sheet 31 and the protective layer 33 and the lower the occurrence of distortion, deformation, cracking, or the like. From the above viewpoints, among the resins described above as a material for the substrate sheet 11, a polycarbonate resin is preferable for the substrate sheet 31. This is because, in the case where a phenoxy resin or polyvinyl butyral resin having a glass transition temperature Tg of 70°C or more and 150°C or less is used as a thermoplastic resin, since the glass transition temperature Tg of a polycarbonate resin is 150°C and close to the glass transition temperatures Tg of these resins, distortion, deformation, cracking, or the like is unlikely to occur when the sensor sheet 30 is formed into a three-dimensional shape.

### <Sensor Sheet (Part 3)>

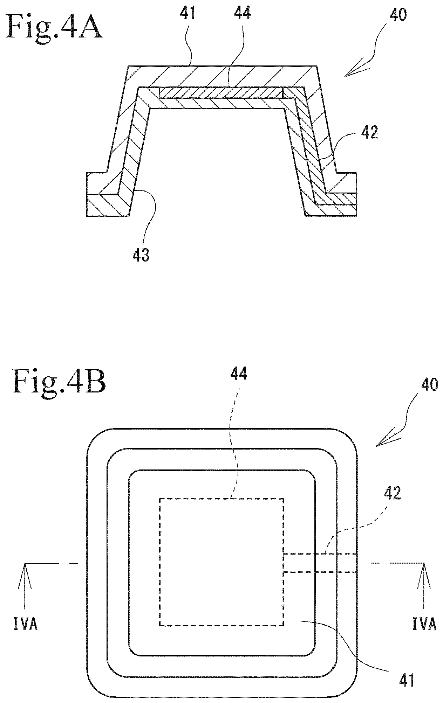

Figs. 4A and 4B are front and plan views, respectively, of a sensor sheet 40 according to still another embodiment. The sensor sheet 40 illustrated in the drawings is the same as the above-described sensor sheet 20 in that a circuit wire (conductive wire 42) and a sensor electrode 44 that are disposed on a substrate sheet 41 are covered with a protective layer 43 formed by application of the coating film-forming composition. However, the sensor sheet 40 is three-dimensionally formed by bending or stretching so as to be protruded from a surface of the sensor sheet 40 which is opposite to the surface in which the protective layer 43 is disposed. Note that the raw material, etc. of each of the members are the same.

### <Sensor Sheet (Part 4)>

The sensor sheet may be covered with a protective layer after the sensor sheet has been formed in a three-dimensional shape. The protective layer can be formed by applying the coating film-forming composition onto the three-dimensional shaped surface by spray coating or the like.

It will be readily understood by persons skilled in the art that various modifications can be made without substantially departing from the new matter and advantageous effects of the present invention, and such modification examples are all within the scope of the present invention. For example, a term described together with another term that is broader or synonymous at least once in the description or the drawings can be replaced with the other term at any position in the description or the drawings. The structure of the embodiment is not limited to that described in the above embodiment; various modifications can be made.

### EXAMPLES

### <Preparation of Samples 1 to 11>

The present invention is further described on the basis of Examples (Comparative Examples) below. Coating film-forming compositions was each prepared by mixing a thermoplastic resin with a solvent (diethylene glycol monobutyl ether) as described in the table below at a ratio of 25:75 by weight and dissolving the thermoplastic composition in the solvent. Hereby, samples 1 to 11 were prepared.

On the surface of a polycarbonate film used as a substrate sheet, a conductive wire having a thickness of 5 um and a line width of 100 um was formed using a silver paste (product name; LS-610-3, produced by Asahi Chemical Research Laboratory Co., Ltd.). Subsequently, one of the coating film-forming compositions of the samples 1 to 11 was applied onto the surface of the substrate sheet to form a protective layer having a thickness of 6 um. Hereby, a test circuit sheet that included a conductive wire and a protective layer covering the conductive wire was prepared. The test circuit sheets were each assigned with the same sample number as the coating film-forming composition applied.

**Table 1]**

| | | | Sample 1 | Sample 2 | Sample 3 | Sample 4 | Sample 5 | Sample 6 | Sample 7 | Sample 8 | Sample 9 | Sample 10 | Sample 11 |
|---|---|---|---|---|---|---|---|---|---|---|---|---|---|
| Composition | Thermoplastic resin | Type | Phenoxy resin | Phenoxy resin | Phenoxy resin | Phenoxy resin | Phenoxy resin | Phenoxy resin | Phenoxy resin | Polyvinyl butyral | Polyvinyl butyral | Polyvinyl butyral | Acrylic resin |
| | | Name | JER1256 | JER4250 | JER4275 | YP-50 | YP-50S | YP-70 | FX-310 | BL-1 | BL-S | BX-L | CR-80T-2 |
| | | Tg(°C) | 95 | 70 | 68 | 84 | 84 | 72 | 110 | 70 | 61 | 80 | 110 |
| | | Hydroxyl value (mgKOH/g) | 190 | 180 | 170 | 197 | 284 (322-241) | 270 | 164 | 328 | 187 | 287 | 0 |
| | | Mn | 10000 | 9000 | 8000 | 9900 | 11300 | 10200 | 9500 | 19000 | 23000 | 18000 | - |
| | | Mw | 50000 | 60000 | 60000 | 78000 | 46200 | 39700 | 45000 | - | - | - | - |
| Test results | Viscosity | | A | A | A | A | A | A | A | A | A | A | A |
| | Adhesion | | A | A | B | A | A | A | B | A | B | A | A |
| | Sulfur resistance (circuit sheet) | | A | B | C | A | A | B | B | B | C | B | C |
| | Sulfur resistance (three-dimensional formed article) | | A | B | C | A | A | B | B | B | C | B | C |

The types and names of the thermoplastic resins listed in Table 1 are as follows.
- Phenoxy resin:
   JER1256 (bisphenol A type, produced by Mitsubishi Chemical Corporation)
   JER4250 (bisphenol A/bisphenol F mixed type, produced by Mitsubishi Chemical Corporation)
   JER4275 (bisphenol A/bisphenol F mixed type, produced by Mitsubishi Chemical Corporation)
- Phenoxy resin:
   YP-50 (bisphenol A type, produced by NIPPON STEEL Chemical & Material Co., Ltd.)
   YP-50S (bisphenol A type, produced by NIPPON STEEL Chemical & Material Co., Ltd.)
   YP-70 (bisphenol A/bisphenol F copolymer type, produced by NIPPON STEEL Chemical & Material Co., Ltd.)
   FX-310 (produced by NIPPON STEEL Chemical & Material Co., Ltd.)
- Polyvinyl butyral:
   BL-1 (produced by SEKISUI CHEMICAL CO., LTD.)
   BL-S (produced by SEKISUI CHEMICAL CO., LTD.)
   BX-L (produced by SEKISUI CHEMICAL CO., LTD.)
- Acrylic resin:
   CR-80T-2 (paint composition, produced by Asahi Chemical Research Laboratory Co., Ltd.)

### <Tests>

Each of the samples was subjected to the tests described below.

[Printability 1] Viscosity: The viscosity of each of the samples was determined in order to evaluate printability in terms of viscosity. Table 1 lists the results in the column "Viscosity".

Viscosity was evaluated as follows: an evaluation of "A" was given when the sample had a viscosity at which screen printing could be performed using the sample with no problem; an evaluation of "B" was given when the sample had a relatively high viscosity that was not suitable for mass production, at which, for example, screen printing could be performed but a printing speed could not be increased; and an evaluation of "C" was given when the sample had a high viscosity at which printing could not be performed.

[Coating Film Quality 1] Adhesion: Each of the samples was subjected to an adhesion test in order to evaluate the quality of the coating film in terms of adhesion to the substrate sheet.

Specifically, the adhesion evaluation was conducted by sticking an adhesive tape onto the surface in which the protective layer was present and stripping off the tape quickly and strongly. The tape used for the test was a cellophane adhesive tape stipulated by JIS Z 1522:2009 and had a width of 15 mm.

Adhesion was evaluated as follows: an evaluation of "A" was given when the protective layer remained adhered on the substrate sheet after the adhesion test had been conducted and nothing was changed; an evaluation of "B" was given when the protective layer did not detach from the substrate sheet but a slight change was observed between the substrate sheet and the protective layer; and an evaluation of "C" was given when the protective layer detached from the substrate sheet.

[Coating Film Quality 2] Sulfur Resistance 1: A sulfur resistance test was conducted in order to evaluate the quality of the coating film in terms of sulfur resistance. In the test for sulfur resistance 1 described below, the test circuit sheet of each of the samples was charged in an enclosed space in which a sulfur powder was placed and left to stand in a saturated sulfur vapor atmosphere at 85°C for 288 hours. After the lapse of 288 hours, the conditions of the conductive wire were inspected visually and by measuring the resistance value thereof.

Sulfur resistance was evaluated as follows: an evaluation of "A" was given when neither a change in the color of the conductive wire nor the rupturing (insulation) of the conductive wire occurred; an evaluation of "B" was given when a change in the color of the conductive wire was observed while the conductive wire did not rupture; and an evaluation of "C" was given when the conductive wire ruptured.

[Coating Film Quality 3] Sulfur Resistance 2: In the test for sulfur resistance 2 described below, which is one of the sulfur resistance tests, a test circuit sheet of each of the samples was formed into a three-dimensional shape by being bent and stretched so as to be protruded from a surface of the circuit sheet in which the coating film was disposed, and the resulting test circuit sheet was subjected to a test under the same conditions as in the sulfur resistance test 1.

Note that the three-dimensional test circuit sheet, which had been formed into a three-dimensional shape, was prepared as described below, and the sulfur resistance evaluation was conducted as in the test for sulfur resistance 1.

The circuit sheet was heated and pressed against a mold having an intended protruded shape by vacuum forming in order to form the circuit sheet by bending and stretching. Then, the circuit sheet was cooled and released from the mold. Hereby, a circuit sheet formed into a three-dimensional shape was prepared. The mold used was a cylindrical mold having a diameter of 48 mm and a height of 10 mm on the plane and including side surfaces having an angle of inclination of 87 degrees. The temperature of the mold was 90°C. The heating temperature of the circuit sheet was 180°C (heating was performed for 12 seconds with a heater heated at 350°C).

### <Discussions>

The results of the two sulfur resistance tests of the samples 3 and 9, which included a phenoxy resin or polyvinyl butyral resin as a thermoplastic resin and the glass transition temperature Tg was less than 70°C and 68°C or less, respectively, and the sample 11, which included an acrylic resin paint as a thermoplastic resin, were unfavorable. In contrast, the results of the two sulfur resistance tests of the samples 1, 2, 4 to 8, and 10, which had a glass transition temperature Tg of 70°C or more and a hydrogen-bonding functional group, were equal to or more than B, that is, favorable. In the samples 1, 2, 4 to 8, and 10, the hydroxyl value fell within the range of 180 mgKOH/g or more and 330 mgKOH/g or less. However, as is seen from the fact that the results of the two sulfur resistance tests of the sample 9 were unfavorable, it was confirmed that the glass transition temperature Tg needs to fall within the range of 70°C or more and 150°C or less even when the hydroxyl value falls within the range of 180 mgKOH/g or more and 330 mgKOH/g or less. It was also found that the sample 7, which was evaluated as "B" in terms of adhesion, had a hydroxyl value of less than 180 mgKOH/g. In particular, the samples 1, 4, and 5, which included a bisphenol-A phenoxy resin as a thermoplastic resin, were evaluated as "A" in the sulfur resistance tests even after the circuit sheet had been formed into a three-dimensional shape. That is, markedly favorable results were obtained.

### Reference Signs List

- 10: CIRCUIT SHEET
- 11: SUBSTRATE SHEET
- 12: CONDUCTIVE WIRE (CIRCUIT WIRE)
- 13: PROTECTIVE LAYER (COATING FILM)
- 20: SENSOR SHEET
- 21: SUBSTRATE SHEET
- 22: CONDUCTIVE WIRE (CIRCUIT WIRE)
- 23: PROTECTIVE LAYER (COATING FILM)
- 24: SENSOR ELECTRODE
- 30: SENSOR SHEET
- 31: SUBSTRATE SHEET
- 32: CONDUCTIVE WIRE (CIRCUIT WIRE)
- 33: PROTECTIVE LAYER (COATING FILM)
- 34: SENSOR ELECTRODE
- 40: SENSOR SHEET
- 41: SUBSTRATE SHEET
- 42: CONDUCTIVE WIRE (CIRCUIT WIRE)
- 43: PROTECTIVE LAYER (COATING FILM)
- 44: SENSOR ELECTRODE

## Claims

1. A circuit sheet comprising:
a substrate sheet;
a circuit wire disposed on the substrate sheet, the circuit wire including silver, copper, or a conductive polymer; and
an electrically insulating protective layer that covers the circuit wire,
the protective layer being a coating film including a thermoplastic resin having a hydrogen-bonding functional group and a glass transition temperature Tg of 70°C or more and 150°C or less, the thermoplastic resin including at least one selected from an epoxy resin, a phenoxy resin, polyvinyl alcohol, polyvinyl acetal, polyvinyl butyral, and an ethylene-vinyl alcohol copolymer.

2. The circuit sheet according to Claim 1, wherein the hydrogen-bonding functional group of the thermoplastic resin is a hydroxyl group, and the thermoplastic resin has a hydroxyl value of 180 mgKOH/g or more and 330 mgKOH/g or less.

3. The circuit sheet according to Claim 1, wherein the thermoplastic resin has a number-average molecular weight Mn of 2,000 or more and 130,000 or less or a weight-average molecular weight Mw of 5,000 or more and 200,000 or less.

4. The circuit sheet according to Claim 1, wherein the protective layer does not include a crosslinking agent.

5. The circuit sheet according to Claim 1, wherein the thermoplastic resin is a bisphenol-A phenoxy resin.

6. The circuit sheet according to Claim 1, wherein the thermoplastic resin is a polyvinyl butyral resin having a hydroxyl value of 280 mgKOH/g or more and 330 mgKOH/g or less.

7. The circuit sheet according to Claim 1, wherein the protective layer includes at least one additive selected from a humidity resistance improver, a sulfur resistance improver, a gas barrier property improver, a lightfastness improver, an ultraviolet inhibitor, and an adhesion improver, and a content of the at least one additive in the protective layer is 0.1% by volume or more and 15% by volume or less.

8. The circuit sheet according to Claim 1, wherein the protective layer is bent or stretched.

9. The circuit sheet according to Claim 1, wherein the substrate sheet has a glass transition temperature Tg of 100°C or more and 150°C or less.

10. A sensor sheet comprising:
the circuit sheet according to any one of Claims 1 to 9; and
a sensor electrode disposed on the substrate sheet, the sensor electrode including silver, copper, or a conductive polymer,
wherein the protective layer included in the circuit sheet is an electrically insulating protective layer that covers the circuit wire included in the circuit sheet and the sensor electrode.

11. A coating film-forming composition comprising a thermoplastic resin having a glass transition temperature Tg of 70°C or more and 150°C or less and a solvent, the thermoplastic resin including at least one selected from an epoxy resin, a phenoxy resin, polyvinyl alcohol, polyvinyl acetal, polyvinyl butyral, and an ethylene-vinyl alcohol copolymer, the thermoplastic resin having a hydrogen-bonding functional group.

12. The coating film-forming composition according to Claim 11, wherein the hydrogen-bonding functional group of the thermoplastic resin is a hydroxyl group, and the thermoplastic resin has a hydroxyl value of 180 mgKOH/g or more and 330 mgKOH/g or less.

13. The coating film-forming composition according to Claim 11, wherein the thermoplastic resin has a number-average molecular weight Mn of 2,000 or more and 130,000 or less or a weight-average molecular weight Mw of 5,000 or more and 200,000 or less.

14. The coating film-forming composition according to Claim 11, not comprising a crosslinking agent.

15. The coating film-forming composition according to Claim 11, wherein the thermoplastic resin is a bisphenol-A phenoxy resin.

16. The coating film-forming composition according to Claim 11, wherein the thermoplastic resin is a polyvinyl butyral resin having a hydroxyl value of 280 mgKOH/g or more and 330 mgKOH/g or less.
